# EUROPEAN PATENT APPLICATION

(11) **EP 1 309 083 A1**
(43) Date of publication of application: **07.05.2003**
(21) Application number: 01126289.6
(22) Date of filing: 06.11.2001
(51) Int. Cl.: H03G 1/00

(54) **Method for switching the gain of an amplifier and a switched gain low noise amplifier**

(71) Applicant: SIEMENS AKTIENGESELLSCHAFT, 80333 München (DE)
(72) Inventor: Iversen, Christine Rye, 9380 Vestbjerg (DK)

(57) **Abstract**

The present invention relates to a Method for switching the gain of an amplifier, a switched gain low noise amplifier, a transmitting and/or receiving unit and a RF-system for data transmission between a mobile user equipment and a base station.

The object of the present invention is to provide a switched gain low noise amplifier, a transmitting and/or receiving unit and a RF-system for data transmission having an improved efficiency and enhanced quality of the output signal in any of the gain states available.

As a solution a method according to the present invention proposes that an input signal IN is connected to a switching circuit SC after passing a input matching circuit and an output signal of the switching circuit SC is feed back into a signal path P the low noise amplifier LNA prior to an output matching circuit and transistor switches M3, M4, M5 of the switching circuit SC are controlled by a gain control signal GC switching the complex impedance realised by the switching circuit SC to a high level for high gain mode of the amplifier and switching the switching circuit SC to a low level for low gain mode of the amplifier, where the load is matched to input and output in both states respectively.

## Description

The present invention relates to a method for switching the gain of an amplifier, a switched gain low noise amplifier, a transmitting and/or receiving unit and a RF-system for data transmission between a mobile user equipment and a base station.

Within the field of radio communication, such as satellite communication or mobile communication, there is an increasing need of less power consuming amplifier devices. For safe information signal recovery low noise amplifiers LNAs are used in this field.

However, more complex methods of coding, modulation and strict standards are used to enhance the quality of wireless information transmission decreasing power consumption, too. So the Global Standard for Mobile communication GSM became extended to Enhanced Data rate for GSM Evolution, GSM-EDGE, using a quadrature modulation technique to meet the aforesaid needs. Further the Universal Mobile Telecommunication Standard UMTS contains mixtures of Time domain multiple access TDMA coding and Frequency domain multiple access coding. Additionally there are special hardware requirements. In any of the aforesaid standards desirable requirement for a switched gain LNA typically are:
- High gain state having about 10 - 20 dB power gain
- Low gain state showing about -10dB gain
- Input and output port matched to system impedance in both gain states
- Zero power consumption in low gain state.

The high gain of 10 to 20 dB is typically required to fulfill the receiver sensitivity requirements. A low gain of approximately -10dB is often desirable since this allows the LNA to operate in a passive mode at zero power consumption in the low gain state and still provide adequate isolation between the preceding an succeeding passive filters. A higher gain in the low gain state distorts filter characteristics, due to unintended filter interaction. On the other hand a lower gain reduces receiver sensitivity in low gain mode and thus limits the signal level range where this mode can be applied. The power consumption reduction form coming from operation the LNA in low gain mode is thus reduced to cases with very high signal levels.

However, the gain of the amplifier device has to match the needs of an input system or an output system respectively where the input signal level of the amplifier device varies in a very large range. Radio frequency amplifiers are typically required to adopt to the level of the received signal. Thus, this kind of amplifier needs to perform some sort of gain control. Gain control can be implemented in various blocks in a radio frequency amplifier chain. Implementing a part of the gain control in the LNA has the benefit of reducing the dynamic range requirements in succeeding circuit blocks in the receiver. Reduced dynamic range requirements allow for a reduction of the receiver power consumption, which is a very important factor regarding the operating time span of battery driven equipment such as mobile telephones.

Switched gain LNAs are known in the state of the art already. US 5,867,778 A discloses a switched gain LNA realized in a silicon bipolar junction transistor technology, where two different supply voltages are switched. Whereas this approach is a rather simplistic way of implementing a switched gain LNA it has some major drawbacks: the passive low gain state in a CMOS LNA is at about -40 to -30 dB due to multistage technology. Further the input impedance match deviates seriously from the required impedance.

However, switched gain LNAs are realized in a Complementary Metal Oxide Semiconductor CMOS technique usually. A switched gain CMOS LNA is disclosed in US 6,038,460A, where the circuit consists of two LNAs named LNA ONE and LNA TWO. Closing a switch forms a short cut concerning LNA ONE with LNA TWO working only. However, linearity often suffers when combining two LNAs as in US 6,038,460A compared to realizing the required gain in just one LNA. In some cases it may be an advantage of the circuit disclosed in US 6,038,460A that it however allows two gain modes with gain in both. But the requirements listed above that are typical for almost any wireless communications receiver LNA show that there is no need for gain in both modes. Further it is rather expensive to supply a circuit having two LNAs.

The object of the present invention is to provide a switched gain low noise amplifier, a transmitting and/or receiving unit and a RF-system for data transmission having an improved efficiency and enhanced quality of the output signal in any of the gain states available. A even further object of the present invention is to achieve the aforesaid objects at a minimised amount of energy consumption reached by a circuit having a reduced number of elements and size.

These objects are achieved by a switched gain low noise amplifier having the features of claim 1. Further these objects are reached using a transmitting and/or receiving unit, a RF-system and a method for switching the gain of an amplifier having the features of claims 7, 9, 10 respectively. The depending claims contain the features of preferred embodiments of the invention respectively.

Therefore, a method for switching the gain of an amplifier according to the present invention is characterized in that an input signal is connected to a switching circuit after passing a input matching circuit and an output signal of the switching circuit is feed back into a signal path the low noise amplifier prior to an output matching circuit. Further transistor switches of the switching circuit are controlled by a gain control signal switching the complex impedance realised by the switching circuit to a high level for high gain mode of the amplifier and switching the switching circuit to a low level for low gain mode of the amplifier where the load is matched to input and output in both states respectively.

Accordingly a switched gain low noise amplifier realised in a Complementary Metal Oxide Semiconductor CMOS technique containing a low noise amplifier is characterized in that a switching circuit is connected into the input and output matching circuits in parallel to the amplifier core, the switching circuit containing two switches of complementary channel type being connected in series having means for input and output matching and the switches being supplied with a gain control signal and the inverted gain control signal to have the same state respectively.

The circuit proposed always results in loss in the low gain mode. Typically this is required. The gain achievable in a high gain mode is adjustable as described hereafter referring to a preferred embodiment of the invention.

In a preferred embodiment of the present invention the switching circuit is supplied with resistors and capacitor located between the switches. These means are used for setting the input and output match and further they are used for adjusting the gain in low gain mode.

Further it is advantageous to arrange the switching transistors in a way within the switching circuit implementing a series - shunt - series switch. However the shunt defines a potential while the series transistors are switched off enhancing isolation.

In an embodiment of the invention the switch transistors of the switching circuit are fairly small devices being high on resistance. These devices have each a width of only a small fraction of the amplifying transistors of the LNA amplifier respectively thus minimising the parasitic load of the circuit in the high gain mode.

However the method disclosed is described with respect to UMTS requirements only it may also apply in any kind of switched gain radio frequency device or apparatus.

An embodiment of the invention will now be described with reference to the drawings appended where:
- Figure 1:: shows an embodiment according to the present invention;
- Figure 2:: discloses a reduced circuit of Figure 1 representing the low gain mode only with the switching circuit being switched on and
- Figure 3:: discloses a reduced circuit of Figure 1 representing the high gain mode only with the switching circuit being switched off.

A preferred embodiment of a switched gain CMOS LNA according to the present invention builds on an already known CMOS LNA topology, see references [1], [2] for example.

Within the LNA transistors M1 and M2 form a cascade stage, which represents the actual amplifier core. Within the combination of the transistors M1, M2 it is M2 to act as a common gate amplifier. For such an amplifier to work the gate G should be short circuited to ground AC-wise at the frequencies of operation. Thus, capacitor C2 AC decouples the gate of M2 grounding the gate of M2 at RF frequencies.

Inductive source degeneration supplied by inductor L2 is used to generate a real part in the input impedance of this stage. Inductor L1 supplies for impedance match. Capacitor C1 is a DC blocking capacitor. Resistor R1 provides a gate bias voltage for M2. Inductors L3 and L4, and capacitors C4 and C5, form a tapped resonance circuit for the output. Capacitor C3 is supply decoupling. Further, a bias circuit BC delivers the sufficient bias voltage V_{bias} for the cascade stage, typically done using a current mirror approach.

The important addition to the topology of the LNA is a switching circuit SC according to the present invention and the way how it is connected into the aforesaid input and output matching circuits. The present embodiment of a novel switching circuit SW consists of transistors M3, M4 and M5, that implements a series - shunt - series switch. Resistors R2, R5 and capacitor C6 are used for adjusting the gain in low gain mode with M3, M5 being switched on. Further, the resistors R2, R5 and the capacitor C6 are used for setting the input and output match. The resistors R3 and R4 are high value resistors used for ensuring correct DC potentials for M3 and M5.

A logical inverter INV is used to invert the gain mode control signal GC to the gates of the transistors M3, M5 respectively ensuring the transistors M3, M5 have the same state.

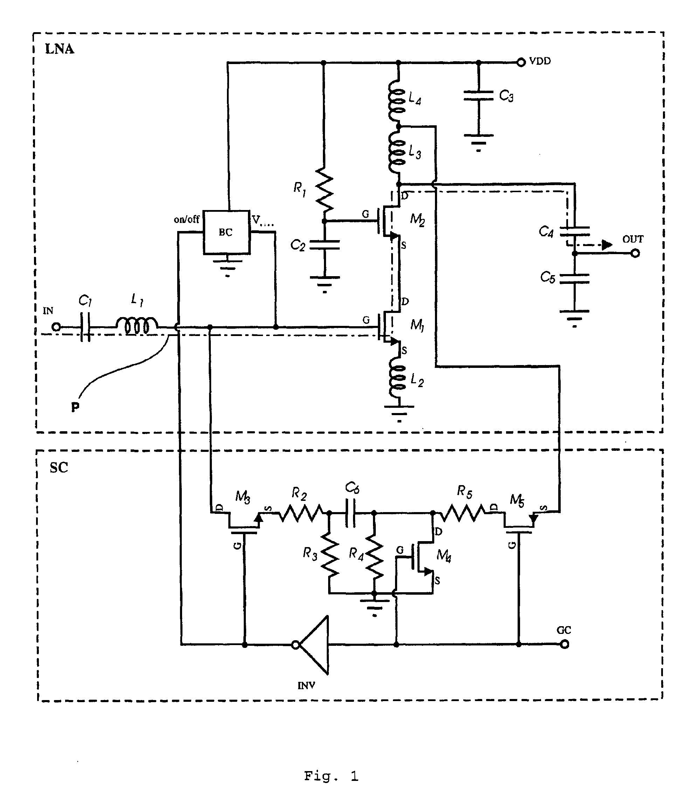

In an other embodiment of the invention the shunt switch M4 is omitted. The shunt switch M4 improves isolation in high gain mode. However, low isolation, i.e. feedback through the switching circuit, may cause amplifier instability in high gain mode. Thus the solution shown in figure 1 is preferred.

The gain control signal GC inverted by an inverter INV is also used for turning on and off the bias circuit BC, and thus the gain control signal GC is used for turning on and off power to the LNA, too.

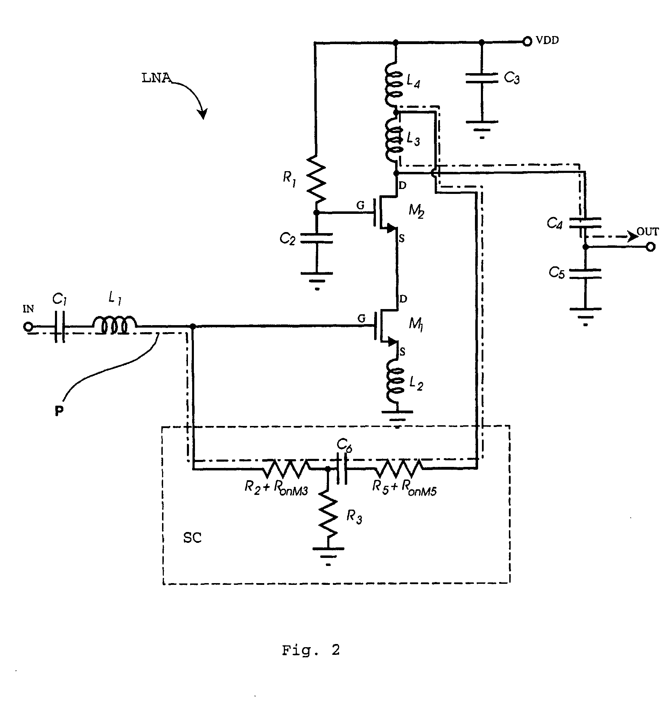

For a better understanding of the function the active part of the whole circuit of figure 1 is shown in figure 2. Here the circuit is reduced to the part working in the low gain mode. However, there is no bias voltage V_{bias} supplied for the gate of the cascade causing an attenuation of about -10 dB together with the branch of the switching circuit SC.

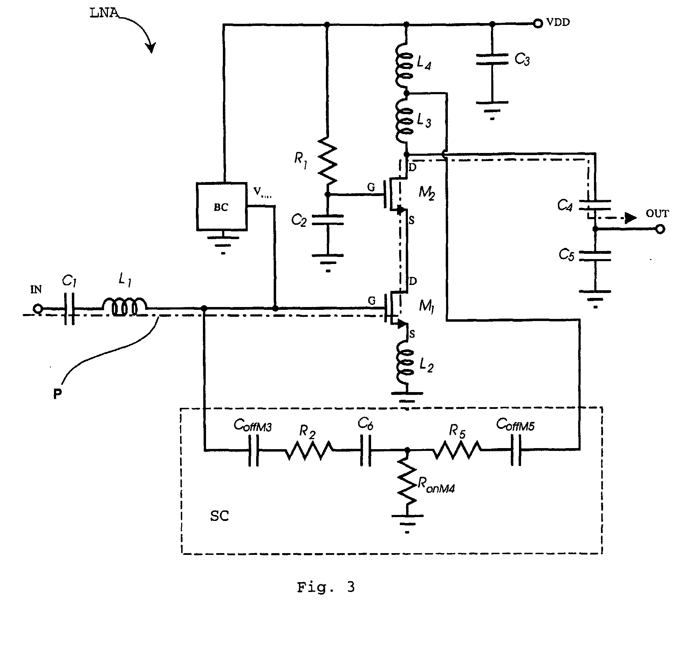

In the high gain mode represented by the reduced circuit of figure 3 there is the gate of the cascade supplied with an adequate bias voltage V_{bias}. The impedance of the switching circuit SC is chosen to prevent attenuation without cutting the branch off. The resistance of transistor M4 being switched on provides for a defined potential value between the transistors M3, M5 switched off.

To draw a conclusion in respect to the state of the art it has to be stated, that switched gain LNAs are seen in other semiconductor technologies [3] implemented using single pole double throw switches at the input and output and thereby bypassing the LNA. This type of circuit is however not very suitable for CMOS implementation since CMOS devices are associated with significant parasitic, which would lead to considerable loss in the input network and thus increased noise.

The presented solution overcomes this problem in an elegant way. In the low gain mode, the LNA amplifier core is simply turned off but it remains still connected to the remainder of the circuit. This state is shown in the reduced circuit shown in the drawing of figure 2 by means of the indicated signal path P running through the switching circuit SC rather than going through the LNA. Thus, there is no need for switches in series with the LNA input and output. However the signal path containing gate terminals and drain terminals of the amplifier core is left untouched.

To bypass the LNA in the low gain mode a connection through the switching circuit SC is established. Since a loss of approximately 10 dB is required through the LNA, the switch transistors M3, M4 and M5 can be fairly small devices being high on resistance, with a width of only a small fraction of the amplifying transistors M1 and M2. By using small switching transistors here the parasitic load of the circuit, in the high gain mode are minimized. In high gain mode the noise figure degradation is thus very small, compared to a non-switched solution.

The present invention is developed for the use in a CMOS radio receiver for UMTS mobile telecommunication. The circuit performance has been verified through circuit simulation. Further a prototype in a 0.25 µm silicon standard CMOS process is in fabrication. The simplified schematic of this circuit of figure 1 shows a version of the switching circuit suitable for a single ended LNA. The presented method works for differential LNAs as well, and is applicable to almost all radio receivers using LNAs in CMOS technology. The requirements listed at the beginning of the description are typical for almost any wireless communications receiver LNA.

However, the influence of the parasitics to CMOS-circuits is very important. This does not only depend on the frequency but also of the circuit topology. Experimental works within a range up to 2 GHz have shown that the influence of parasitics is quite immense. Parasitics start to influence the design above a few hundred MHz. However, the circuit disclosed shows a novel way keeping the influence of parasitics in mind, too.

However, the switching circuit SC disclosed allows minimization and integration together with the LNA within one integrated circuit.

For further information on the state of the art reference is given to the following papers cited above:
[1] Derek K. Shaeffer and Thomas H. Lee. A 1.5V, 1.5 GHz CMOS Low Noise Amplifier. IEEE Journal of Solid State Circuits, Vol. 32, No. 5, pp. 745-759, May 1997.
[2] B. Floyd, J. Mehta, C. Gamero, and K. 0. A 900 MHz, 0.8 µm CMOS Low Noise Amplifier with 1.2 dB Noise Figure. In technical digest of 1999 IEEE Custom Integrated Circuits Conference 1999, pp. 661-664.
[3] R. Moroney, K. Harrignton, W. Struble, B. Khabbaz and M. Murphy. A High Performance Switched-LNA for CDMA Handset Applications. In technical digest of 1998 IEEE Radio Frequency Integrated Circuits Symposium.

Within in text and the drawings the following Abbreviations are used:
- GSM: Global system for Mobile communication
- EDGE: Enhanced Data rates for GSM Evolution
- RF: Radio frequency
- UMTS: Universal Mobile Telecommunication Standard
- LNA: Low Noise Amplifier
- SC: Switching Circuit
- BC: Bias Circuit
- IN: Input
- INV: Inverter
- OUT: Output
- GC: Gain Control
- P: Signal Path
- V_{bias}: Bias potential
- R: Resistor
- C: Capacitance
- L: Inductance
- M: MOS FET
- G: Gate terminal
- AC: Alternating current
- DC: Direct current

## Claims

1. Switched gain low noise amplifier realised in a Complementary Metal Oxide Semiconductor CMOS technique containing a low noise amplifier (LNA),
**characterized in that**
a switching circuit (SC) is connected into the input and output matching circuits in parallel to the amplifier core,
the switching circuit (SC) containing two switches (M3, M5) of complementary channel type being connected in series
having means for input and output matching and
the switches (M3, M5) being supplied with a gain control signal (GC) and the inverted gain control signal (GC) to have the same state respectively.

2. Switched gain low noise amplifier according to claim 1,
**characterized in that**
the switching circuit (SC) is supplied with resistors (R2, R5) and capacitor (C6) located between the switches (M3, M5) being means used for setting the input and output match.

3. Switched gain low noise amplifier according to at least one of the proceeding claims,
**characterized in that**
the switching circuit (SC) is supplied with resistors R2, R5 and capacitor C6 located between the switches (M3, M5) are used for adjusting the gain in low gain mode with M3, M5 being switched on.

4. Switched gain low noise amplifier according to at least one of the proceeding claims,
**characterized in that**
the switches (M3, M5) are supplied with resistors (R3, R4) for ensuring correct DC potentials for the switches (M3, M5), where said resistors (R3, R4) are high value resistors.

5. Switched gain low noise amplifier according to at least one of the proceeding claims,
**characterized in that**
transistors (M3, M4, M5) are arranged in a way within the switching circuit (SC) implementing a series - shunt - series switch.

6. Switched gain low noise amplifier according to at least one of the proceeding claims,
**characterized in that**
the switch transistors (M3, M4, M5) of the switching circuit (SC) are fairly small devices being high on resistance and having width of only a small fraction of the amplifying transistors (M1, M2) of the amplifier (LNA) respectively minimizing the parasitic load of the circuit in the high gain mode.

7. Transmitting and/or receiving unit
**characterized in that**
it contains a switched gain low noise amplifier according to at least one of the proceeding claims.

8. Transmitting and/or receiving unit according to the proceeding claim,
**characterized in that**
it makes part of a mobile user equipment such as a mobile telephone.

9. RF-system for data transmission between a mobile user equipment and a base station,
**characterized in that**
it contains a Transmitting and/or receiving unit according to the proceeding claim and/or a switched gain low noise amplifier according to at least one of the claims 1 to 6.

10. Method for switching the gain of an amplifier, especially a low noise amplifier (LNA) used in a radio frequency receiver or mobile transmitting and/or receiving unit,
**characterized in that**
an input signal (IN) is connected to a switching circuit (SC) after passing a input matching circuit and
an output signal of the switching circuit (SC) is feed back into a signal path (P) the low noise amplifier (LNA) prior to an output matching circuit and
transistor switches (M3, M4, M5) of the switching circuit (SC) are controlled by a gain control signal (GC) switching the complex impedance realised by the switching circuit (SC) to a high level for high gain mode of the amplifier and switching the switching circuit (SC) to a low level for low gain mode of the amplifier,
where the load is matched to input and output in both states respectively.
